(19) Europäisches Patentamt / European Patent Office / Office européen des brevets

(11) **EP 4 734 306 A1**

(12) **EUROPEAN PATENT APPLICATION**

(43) Date of publication:
29.04.2026 Bulletin 2026/18

(21) Application number: 25211141.4

(22) Date of filing: 24.10.2025

(51) International Patent Classification (IPC):
*H02G 5/00* (2006.01)     *H05K 7/14* (2006.01)

(52) Cooperative Patent Classification (CPC):
H02G 5/06; H01R 25/16; H05K 7/1492; H02G 5/007

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 25.10.2024 US 202463712254 P
02.10.2025 US 202563892441 P
21.10.2025 US 202519364006

(71) Applicant: Vertiv Corporation
Westerville, OH 43082 (US)

(72) Inventors:
• FERGUSON, Kevin R.
Westerville, 43082 (US)
• ALDAG, Philip R.
Westerville, 43082 (US)
• KERR, Stephen
Westerville, 43082 (US)

(74) Representative: Ambroz, Simon et al
Kilburn & Strode LLP
Lacon London
84 Theobalds Road
London WC1X 8NL (GB)

(54) **SYSTEMS AND METHODS FOR HIGH PHASE ORDER POWER DISTRIBUTION IN A DATA CENTER**

(57) A system and method configured for six phase power in a data center, such as for a busway, is disclosed. The busway may include one or more busway sections. Each busway section may include a housing, and a plurality of busbars spaced apart in a first direction. The plurality of busbars may include six or more busbars and may be at least partially enclosed by the housing. Each busbar may be disposed along a second direction perpendicular to the first direction and may be parallel to each other busbar of the plurality of busbars. Each busway section may be configured to be removably coupled to two or more output connectors at two or more locations couplable along the second direction. The two or more output connectors may be configured to be inserted from a third direction perpendicular to the first direction and the second direction.

FIG.1

**Description**

CROSS-REFERENCE TO RELATED APPLICATIONS

The present application claims the benefit under 35 U.S.C. § 119(e) of U.S. Provisional Patent Application Serial Number 63/712,254 filed October 25, 2024, and U.S. Provisional Patent Application Serial Number 63/892,441 filed October 2, 2025; and U.S. Nonprovisional Patent application 19/364,006 filed October 21, 2025.

TECHNICAL FIELD

The present disclosure relates generally to data center powertrains, and more particularly to electrical power distribution configurations of a data center powertrain.

BACKGROUND

Conventional data centers may utilize three-phase power distribution systems to deliver electrical power to computing equipment. As computational demands increase, particularly with the deployment of high-density computing equipment such as artificial intelligence processors and graphics processing units, the power requirements per rack may exceed typical power ratings. Traditional three-phase busway systems operating at these higher power levels may require larger conductor cross-sections to handle the increased current per phase, resulting in heavier and bulkier overhead distribution systems that may strain structural support systems and reduce available space.

Three-phase power distribution at higher power densities may generate substantial resistive losses in the conductors, manifesting as waste heat. Furthermore, the harmonic content generated by non-linear loads such as switching power supplies may be more pronounced in three-phase systems, potentially requiring additional filtering equipment or oversized neutral conductors to handle the harmonics.

For power distribution units (PDU) supporting the high-power demands of power supply units (PSU) within or coupled to computer servers used for high performance computing (HPC) and/or artificial intelligence (AI) workload processing, conventional higher ampacity three-phase distribution systems are typically used for power distribution. However, the distribution and termination of large cross-sectional area of current-carrying conductors and the safety requirements for minimum functional insulation spacing between proximate exposed bare conductors and termination elements are limiting factors in power density and constructions of the distribution and supporting equipment enclosures (e.g., such as in a system where 240/415Vac service is required to deliver 200kVA and above).

Therefore, there is a need for a system configured for higher power levels that can address the increasing power density requirements of modern data centers while reducing conductor heating and improving power quality.

SUMMARY

A system and method configured for six phase power for a component (e.g., busway) of a data center is disclosed.

A system for power distribution in a datacenter is disclosed in accordance with one or more illustrative examples of the present disclosure. In one illustrative example, the system for power distribution in a datacenter includes a transformer configured to convert three-phase electric power to six-phase electric power. In another illustrative example, the transformer is configured to be disposed proximate to a source of power. In another illustrative example, the transformer includes a secondary windings including at least six current carrying conductors.

In a further aspect, the source of power may include a floor power distribution unit.

In a further aspect, the at least six current carrying conductors of the secondary windings may be configured to be distributed to one or more racks housing one or more rack appliances via at least one of one or more busways or one or more insulated electrical cables. In a further aspect, the at least one of the one or more busways or the one or more insulated electrical cables may be configured to be utilized to provide poly-phase power to power supply inputs of the one or more rack appliances.

A system configured for six phase power is disclosed in accordance with one or more illustrative examples of the present disclosure. In one illustrative example, the system includes a busway. In another illustrative example, the busway includes one or more busway sections of the busway. In another illustrative example, each busway section includes a housing including a corresponding surface configured to receive a support element configured to suspend the busway in an overhead configuration of a data center. In another illustrative example, each busway section includes a plurality of busbars spaced apart in a first direction, where the plurality of busbars include six or more busbars and are thereby configured for the six phase power, where the plurality of busbars are at least partially enclosed by the housing, where each busbar of the plurality of busbars is disposed along a second direction perpendicular to the first direction and is parallel to each other busbar of the plurality of busbars. In another illustrative example, each busway section is configured to be removably coupled to two or more output connectors at two or more locations couplable along the second direction. In another illustrative example, the two or more output connectors are configured to be inserted from a third direction perpendicular to the first direction and the second direction.

In a further aspect, the plurality of busbars may include seven or more busbars including a first neutral busbar.

In a further aspect, the plurality of busbars may include eight or more busbars including a first neutral busbar and a second neutral busbar.

In a further aspect, the plurality of busbars may be in an isolated-phase configuration such that each busbar of the plurality of busbars is individually physically isolated from each adjacent busbar of the plurality of busbars by at least one of one or more respective airgaps, or a respective cell wall of the housing, where each respective cell wall is configured to be electrically grounded.

In a further aspect, each busbar may be electrically insulated from adjacent cell walls by an electrically-insulating element surrounding at least three sides of each busbar, where the electrically-insulating element is configured to receive a portion of an output connector.

In a further aspect, the plurality of busbars may be in a sandwiched configuration such that each busbar of the plurality of busbars is sandwiched adjacent to, except for one or more solid layers, at least one adjacent busbar of the plurality of busbars, where the one or more solid layers include one or more solid electrically-insulating layers.

In a further aspect, each of the two or more locations along the second direction that is configured to be removably coupled to an output connector may be a discrete, separate location and include a discrete busway output interface, where each busway output interface includes six or more individual terminals, where each individual terminal is electrically coupled to a corresponding busbar of the plurality of busbars, where each individual terminal is configured to receive a corresponding conducting element of the output connector.

In a further aspect, the six or more individual terminals may be arranged in three or more columns spaced apart in the second direction.

In a further aspect, a top and a bottom of the plurality of busbars may each be coupled to a heatsink of the housing, where each heatsink spans at least a portion of a width of the plurality of busbars along the third direction.

In a further aspect, each heatsink may include a plurality of outward-protruding fins configured to dissipate heat.

A method is disclosed in accordance with one or more illustrative examples of the present disclosure. In one illustrative example, the method includes providing a busway configured for six phase power. In another illustrative example, the busway includes one or more busway sections of the busway. In another illustrative example, each busway section includes a housing including a corresponding surface configured to receive a support element configured to suspend the busway in an overhead configuration of a data center. In another illustrative example, each busway section includes a plurality of busbars spaced apart in a first direction, where the plurality of busbars include six or more busbars and are thereby configured for the six phase power, where the plurality of busbars are at least partially enclosed by the housing, where each busbar of the plurality of busbars is disposed along a second direction perpendicular to the first direction and is parallel to each other busbar of the plurality of busbars. In another illustrative example, each busway section is configured to be removably coupled to two or more output connectors at two or more locations couplable along the second direction. In another illustrative example, the two or more output connectors are configured to be inserted from a third direction perpendicular to the first direction and the second direction. In another illustrative example, the method includes coupling the busway to a power input configured to provide the six phase power. In another illustrative example, the method includes transmitting the six phase power to the power input.

In a further aspect, the plurality of busbars may include seven or more busbars including a first neutral busbar.

In a further aspect, the plurality of busbars may include eight or more busbars including a first neutral busbar and a second neutral busbar.

In a further aspect, the plurality of busbars may be in an isolated-phase configuration such that each busbar of the plurality of busbars is individually physically isolated from each adjacent busbar of the plurality of busbars by at least one of one or more respective airgaps, or a respective cell wall of the housing, where each respective cell wall is configured to be electrically grounded.

In a further aspect, each busbar may be electrically insulated from adjacent cell walls by an electrically-insulating element surrounding at least three sides of each busbar, where the electrically-insulating element is configured to receive a portion of an output connector.

In a further aspect, the plurality of busbars may be in a sandwiched configuration such that each busbar of the plurality of busbars is sandwiched adjacent to, except for one or more solid layers, at least one adjacent busbar of the plurality of busbars, where the one or more solid layers include one or more solid electrically-insulating layers.

In a further aspect, each of the two or more locations along the second direction that is configured to be removably coupled to an output connector may be a discrete, separate location and include a discrete busway output interface, where each busway output interface includes six or more individual terminals, where each individual terminal is electrically coupled to a corresponding busbar of the plurality of busbars, where each individual terminal is configured to receive a corresponding conducting element of the output connector.

In a further aspect, the six or more individual terminals may be arranged in three or more columns spaced apart in the second direction.

In a further aspect, a top and a bottom of the plurality of busbars may each be coupled to a heatsink of the housing, where each heatsink spans at least a portion of a width of the plurality of busbars along the third direction.

In a further aspect, each heatsink may include a plurality of outward-protruding fins configured to dissipate heat.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are exemplary and explanatory only and are not necessarily restrictive of the subject matter claimed.

BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims.

FIG. 1 illustrates a schematic block diagram of a system including a powertrain of a data center, in accordance with one or more examples of the present disclosure.

FIG. 2 illustrates a schematic block diagram of a system including a busway configured for six phase power, in accordance with one or more examples of the present disclosure.

FIG. 3A illustrates a perspective cross-sectional view of a busway in an isolated-phase configuration, in accordance with one or more examples of the present disclosure.

FIG. 3B illustrates an alternate perspective cross-sectional view of the busway in the isolated-phase configuration, in accordance with one or more examples of the present disclosure.

FIG. 3C illustrates an end cross-sectional view of the busway in the isolated-phase configuration, in accordance with one or more examples of the present disclosure.

FIG. 4A illustrates a perspective cross-sectional view of a busway in a sandwiched configuration, in accordance with one or more examples of the present disclosure.

FIG. 4B illustrates an end cross-sectional view of the busway in the sandwiched configuration, in accordance with one or more examples of the present disclosure.

FIG. 4C illustrates an enlarged perspective view of a busway output interface of the busway in the sandwiched configuration, in accordance with one or more examples of the present disclosure.

FIG. 4D illustrates a perspective view of one busway output interface on each side of a joint of the busway in the sandwiched configuration, in accordance with one or more examples of the present disclosure.

FIG. 4E illustrates a perspective view of a cover of the joint of the busway in the sandwiched configuration, in accordance with one or more examples of the present disclosure.

FIG. 4F illustrates a zoomed-out perspective view of the busway in the sandwiched configuration, in accordance with one or more examples of the present disclosure.

FIG. 5 illustrates a diagram of an electrical configuration and a waveform of the busway, in accordance with one or more examples of the present disclosure.

FIG. 6 illustrates a flow diagram depicting a method, in accordance with one or more examples of the present disclosure.

FIG. 7 illustrates a double star transformer, in accordance with one or more examples of the present disclosure.

FIG. 8 illustrates a rack PDU, in accordance with one or more examples of the present disclosure.

FIG. 9 illustrates a power chart for a three-phase primary circuit, in accordance with one or more examples of the present disclosure.

FIG. 10 illustrates a power chart for a six-phase line-line secondary circuit, in accordance with one or more examples of the present disclosure.

FIG. 11 illustrates a power chart for a three-phase line-line secondary circuit, in accordance with one or more examples of the present disclosure.

FIG. 12 illustrates a power chart for a three split-phase line-line secondary circuit, in accordance with one or more examples of the present disclosure.

FIG. 13 illustrates conductor spacing, in accordance with one or more examples of the present disclosure.

DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

Broadly speaking, examples of the concepts disclosed herein may provide six phase power for a data center, such as to a busway. Six phase power distribution in data center environments may provide various operational advantages over traditional three-phase systems. For example, six phase power configurations may enable the use of lower operating voltages for an equivalent power delivery capacity, which improves safety margins. Additionally, the increased number of phases, for a given capacity, results in reduced current per phase, leading to decreased resistive losses and lower heat generation in the conductors. Furthermore, six phase systems may exhibit improved power quality characteristics, including reduced harmonics. The distributed nature of the current across six phases rather than three also enables the use of smaller individual conductor cross-sections and/or less spacing between conductors which may, counterintuitively for a higher number of conductors, allow for more compact busway designs that maximize the utilization of available overhead space in data center environments compared to three-phase designs.

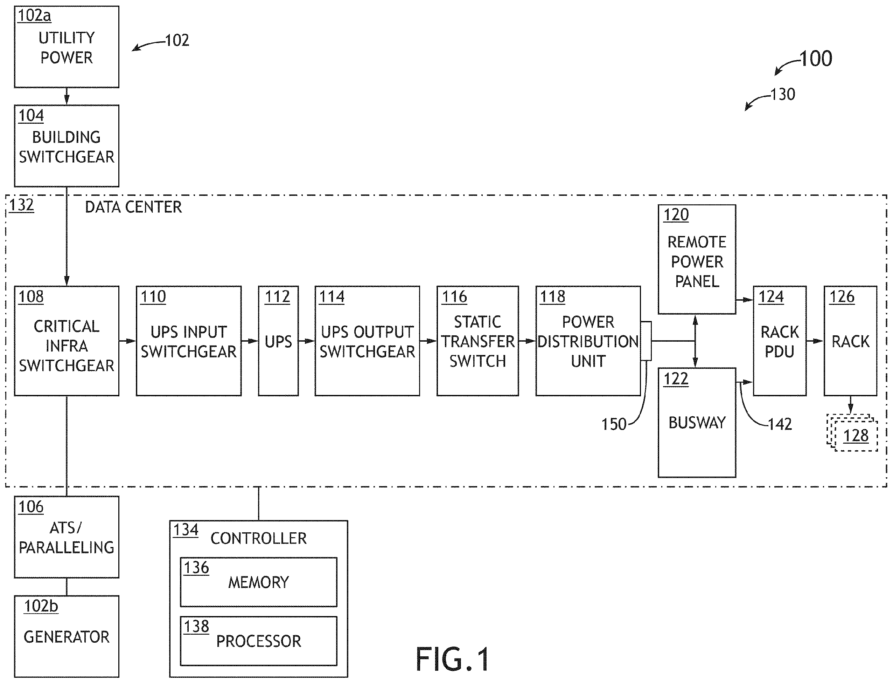

FIG. 1 illustrates a schematic block diagram of a system 100 including a powertrain 130 of a data center 132, where the powertrain includes a busway 122, in accordance with one or more examples of the present disclosure.

In examples, the powertrain 130 includes one or more components configured to generate, distribute, and/or utilize electrical power in the data center 132.

For example, the components of the powertrain 130 may provide power (e.g., provide utility power 102a or generated power from a generator 102b or the like, provide battery backup power), modulate power (e.g., convert voltages, convert phase configurations, and/or the like), protect components (e.g., using circuit breakers, fuses, and/or the like), distribute power (e.g., carry power through one or more components to rack appliances 128 (e.g., rack-mounted compute devices such as GPUs, CPUs), monitor power and/or components (e.g., monitor for electrical faults and status), and/or the like.

For purposes of the present disclosure, "data center" includes any building, room, set of rooms, or area configured for computing operations, such as an area primarily configured for computing operations. For example, a data center may be controlled and/or maintained by a single entity to serve one or more entities (e.g., the same entity, other entities, or the like). A data center may include server racks with rack appliances or the like configured to provide one or more outputs, such as output data from computationally intensive operations (e.g., data processing, cloud-based applications, cloud-based communications, artificial intelligence model inference, artificial intelligence model training, and/or the like).

Note that the arrangements shown herein are nonlimiting and for illustrative purposes only. In examples, the one or more components of the powertrain 130 may include any suitable components in any suitable arrangement. The one or more components of the powertrain 130 may be housed in any suitable location, such as in separate or combined cabinets, embedded in walls, routed using cabling under the floor, routed overhead (e.g., busway), and/or the like.

The one or more components of the powertrain 130 may include, but are not necessarily limited to, one or more of the following components: switchgear 104, 106, 108, 110, 114; uninterruptible power supply (UPS) 112, static transfer switch (STS) 116, power distribution unit (PDU) 118, remote power panel (RPP) 120, busway 122, rack power distribution unit (rPDU) 124, rack 126, or the like.

Each of the components of the powertrain 130 may, but is not necessarily required to, include electrical interfaces (e.g., input/output electrical contacts such as metal plates, busbars, terminals, wire leads, lugs, soldered circuitry connections, sockets, electrical connectors configured to be removably coupled such as plugs, and/or the like). For example, the electrical interfaces may include one or more input electrical interfaces configured to be coupled to one or more elements (e.g., first corresponding electrical interfaces) to receive power and one or more output electrical interfaces configured to be coupled to one or more other elements (e.g., second corresponding electrical interfaces) to output (e.g., distribute) power to one or more other elements. For example, an output (e.g., conducting plates with lugs) of a PDU may be coupled to cables or plates configured to transfer the power from the output of the PDU to an input of an RPP or busway. Such inputs and outputs may be used between any suitable components.

For purposes of the present disclosure, a "cable" or like term includes any conductor that is flexible along at least a portion of its length, such as an insulated wire, bundle including multiple insulated wires with electrical couplers on each end, flexible cable whips inside conduit, and/or the like.

For purposes of the present disclosure, "switchgear" includes an assembly of electrical disconnect switches, fuses, circuit breakers, relays, and/or other protective devices configured to control, protect, and isolate electrical equipment within the powertrain 130 of a data center 132. Switchgear may be configured to de-energize equipment (e.g., turn off power) to allow for safe maintenance, to clear downstream faults, and to provide operational control over the distribution of electrical power. In examples, switchgear may be arranged in one or more cabinets or enclosures and may be located at various points in the powertrain, such as at the input from utility power, at generator outputs, upstream or downstream of uninterruptible power supplies (UPS), and/or at other suitable locations. Switchgear may include low-voltage, medium-voltage, or high-voltage components, and may be configured for manual or automatic operation. Switchgear may further include monitoring and control interfaces, such as sensors, status indicators, and communication modules, to support remote or automated management of electrical power distribution and protection within the data center. However, note that this is a nonlimiting example and that switchgear may include any suitable configuration or combination of devices for controlling and protecting electrical power distribution in the system 100.

For purposes of the present disclosure, "ATS/paralleling switchgear 106" includes one or more cabinets configured to automatically transfer the load between power sources 102 and/or synchronize and parallel multiple generators to a common bus. In some examples, the ATS/paralleling switchgear 106 controls power source and feeder breakers, performs open- or closed-transition transfers, synchronizes voltage, frequency, and phase, manages load sharing and shedding, and supports black-start, islanded operation, and retransfer to utility upon restoration. The ATS/paralleling switchgear 106 may include protective devices, metering, and control/communications interfaces and may be implemented as a standalone assembly or integrated with building switchgear 104 or other switchgear (e.g., 108, 110, 114).

For purposes of the present disclosure, an "uninterruptible power supply (UPS)" includes a component configured to provide backup electrical power to downstream equipment in the event of a loss, degradation, or failure of power from a power source (e.g., primary power source). In examples, the UPS may be configured to supply power for a limited duration, such as during a utility outage, brownout, or other power loss event, thereby allowing for continued operation of critical computing equipment and/or safe shutdown procedures. The UPS may include one or more energy storage elements, such as batteries, capacitors, or the like, and may further include power conversion circuitry (e.g., inverters, rectifiers, chargers) to convert stored energy into a suitable output form (e.g., AC or DC power) for downstream loads. In examples, the UPS may be implemented as a standalone cabinet, integrated within switchgear, distributed across multiple units, and/or the like and may be located upstream or downstream of other powertrain components (e.g., between input switchgear 110 and output switchgear 114). However, note that this is a nonlimiting example and that the UPS may include any suitable configuration or arrangement for providing uninterruptible power to computing operations within the data center 132.

For purposes of the present disclosure, a "Static Transfer Switch (STS)" includes a component configured to maintain power to downstream equipment by automatically transferring the power load between at least two independent power sources. For example, the STS may be configured to automatically transfer power load from a first power source 102 (e.g., utility power 102a) to a second power source 102 upon degradation or loss of power from the first power source. The STS may also be configured to allow planned maintenance on one source path while sustaining the load from an alternate power source to provide power continuity. In examples, the STS may include a switch element (e.g., solid-state switch element) configured to select the power source and provide rapid transfers. The STS may be a standalone cabinet located between UPS output switchgear 114 and a Power Distribution Unit (PDU) 118 or the like. However, note that this is a nonlimiting example and that the STS may be located in any suitable location and include any suitable elements.

For purposes of the present disclosure, a "power distribution unit (PDU)" includes a component configured to receive electrical power from an upstream source (e.g., switchgear, uninterruptible power supply (UPS), static transfer switch (STS), or the like) and distribute the received power to multiple downstream components within a data center environment. In examples, a PDU may be configured to step down voltage, convert electrical phases, isolate electrical faults, and/or distribute electrical power to various subsystems (e.g., remote power panels (RPPs), busways, rack power distribution units (rPDUs), or equipment racks). The PDU may include transformers, circuit breakers, monitoring electronics, power quality meters, relays, surge protection, and/or other suitable electrical components to control and/or monitor the distribution of electrical power.

A PDU may be installed in a floor-standing enclosure or integrated within a cabinet based on the architectural requirements of the data center. In some examples, the PDU may include intelligent features (e.g., remote monitoring, communications interfaces, fault detection, energy consumption logging, remote switching, and the like) for coupling to a controller (e.g., controller 134) configured to monitor the system (e.g., controller configured as a building management system (BMS) or data center infrastructure management (DCIM) platform). The PDU may be configured to provide reliable and redundant electrical pathways to ensure continuous power delivery to downstream loads, such as server racks, and to facilitate maintenance, scalability, and flexibility in the data center. However, note that these are nonlimiting examples, and a PDU may include any configuration suitable for the receipt, conversion, monitoring, and/or distribution of power to support computing operations in a data center.

For purposes of the present disclosure, a "Remote Power Panel (RPP)", or power panel, includes a component configured to provide electrical protection to the computing operations or the like. For example, an RPP may be configured to provide branch-circuit protection and/or monitoring in proximity to computing operations to support visibility of power distribution within a data center white space. The RPP may be configured to distribute power from the PDU to equipment racks by supplying branch circuits positioned proximate to the rPDU and the rack 126. In examples, the RPP includes elements arranged for at least one of floor-standing or wall-mount installation, with one or more openings configured for cable entry. The RPP may include any suitable elements such as fuses, relays, and/or the like. However, note that this is a nonlimiting example and that the RPP may include any configuration suitable for protecting computing operations of a data center 132. The RPP may be configured to provide the power via one or more cables (e.g., cables below the floor), as an alternative to a busway.

For purposes of the present disclosure, a "busway" includes a component configured to distribute power overhead along one or more conductors configured to reduce under-floor cabling by shifting distribution overhead. For example, each busway section may include metallic conductor strips or bar-shaped conductor elements, referred to as "busbars". The conductors may, unlike insulated cables, be configured to be coupled to provide power output from two or more locations along their length. The busbars may be rigid, and parallel. The busbars may be bare metal or shuttered and may allow coupling at particular points or at any point along the length. In examples, the busway may include straight sections, fittings, joints, and the like coupled end-to-end, with housings of each section configured for hot-swappable insertion of couplable components (e.g., tap-off units, whips, or the like). In examples, the busway may be configured to provide power to multiple racks, such as to multiple rack PDUs 124. However, note that this is a nonlimiting example and that the busway may include any overhead hot-swappable architecture suitable for power distribution within the system.

For purposes of the present disclosure, a "rack power distribution unit (rPDU)" includes a component configured to distribute electrical power to one or more rack appliances (e.g., computing devices including GPUs, CPUs, or the like) mounted within a rack. In examples, the rPDU may be mounted vertically or horizontally within the rack and may include multiple power output receptacles (e.g., outlets, sockets) for supplying power to rack appliances such as servers, storage devices, networking equipment, or other rack-mounted appliances. The rPDU may be configured to receive input power from an upstream power source, such as a remote power panel (RPP), busway tap-off box, or other suitable source, and to distribute the received power to the connected devices within the rack. The rPDU may include features for power metering, monitoring, and/or control, such as integrated current and voltage sensors, network connectivity for remote monitoring, and/or switching capabilities for individual outlets. In some examples, the rPDU may provide surge protection, circuit breakers, or other protective elements to safeguard connected equipment. The rPDU may be configured for various plug and outlet types to accommodate different equipment requirements. However, note that this is a nonlimiting example and that the rPDU may include any suitable configuration for distributing and/or managing power within a rack in a data center environment.

For purposes of the present disclosure, a "rack" includes any structure or enclosure configured to house, support, and organize one or more computing devices, such as rack appliances. For example, rack appliances may include servers, storage devices, networking equipment, or other electronic components, within a data center. A rack may include a frame, cabinet, or other suitable structure with mounting features (e.g., rails, shelves, brackets) arranged to receive and secure rack appliances in a standardized configuration (e.g., 19-inch or 23-inch rack width). The rack may be configured to facilitate cable management, airflow, and cooling, and may include features such as doors, side panels, and lockable access points for security and maintenance. In examples, the rack may further include integrated or attachable rack power distribution units (rPDUs), environmental sensors, and/or monitoring equipment. The rack may be positioned on the data center floor, within a row of racks, or in any suitable arrangement to support the computing operations of the data center. However, note that this is a nonlimiting example and that the rack may include any structure or configuration suitable for physically supporting, organizing, and/or protecting computing equipment within a data center environment.

For purposes of the present disclosure, a "rack appliance," "compute device," "computing equipment," or like term includes any electronic device configured to be mounted within a rack, such as a server, memory storage array, network switch, router, firewall, or specialized computing hardware (e.g., GPU server, AI accelerator, or the like). Rack appliances may be powered by one or more rPDUs and may be configured for hot-swappable installation, remote management, and integration with data center monitoring systems. However, this is a nonlimiting example, and a rack appliance may include any suitable device for performing computing and/or networking operations in a data center.

For purposes of the present disclosure, a "signal" may include any form of transmitted information, instruction, or data, whether analog or digital, electrical, optical, wireless, or otherwise, that is configured to be communicated between components of the system 100 and/or externally. A signal may include, for example, electrical voltages or currents, digital data packets, control instructions, sensor readings, status indicators, or any other form of communication used to convey information between devices, controllers, sensors, or other elements within the data center. Signals may be transmitted via physical media (e.g., wires, cables, fiber optics) or wirelessly (e.g., radio frequency, infrared), and may be used for purposes such as monitoring, control, synchronization, fault detection, or data exchange. However, note that this is a nonlimiting example, and a signal may include any suitable form or method of conveying information within or between components of the system 100.

The system 100 may include a controller 134 including one or more processors 138 and a memory 136. The controller 134 may be communicatively coupled to any of the one or more components of the powertrain 130. For example, the controller 134 may be configured to receive data from (e.g., electrical power monitoring data of one or more power monitoring sensors) and/or control the one or more components of the powertrain 130. For instance, controlling may include sending a signal configured to direct an opening or closing of a power switch of any component if a fault is detected, or any other type of control of any other aspect.

The one or more processors 138 of controller 134 may include any one or more processing elements known in the art. In this sense, the one or more processors 138 may include any microprocessor device configured to execute algorithms and/or instructions. In one example, the one or more processors 138 may include a desktop computer, mainframe computer system, workstation, parallel processor, or other computer system (e.g., networked computer) configured to execute a program configured to operate the system 100, as described throughout the present disclosure. It should be recognized that the steps described throughout the present disclosure may be carried out by a single computer system or, alternatively, multiple computer systems. In general, the term "processor" may be broadly defined to encompass any device having one or more processing elements, which execute program instructions from a non-transitory memory (e.g., memory 136). Moreover, different subsystems of the system 100 may include processor or logic elements suitable for carrying out at least a portion of the steps described throughout the present disclosure. Therefore, the above description should not be interpreted as a limitation on the present disclosure but merely an illustration.

The memory 136 may include any storage medium known in the art suitable for storing program instructions executable by the associated one or more processors 138. For example, the memory 136 may include a non-transitory memory. For instance, the memory 136 may include, but is not limited to, a read-only memory, a random access memory, a magnetic or optical memory device (e.g., disk), a magnetic tape, a solid state drive and the like. In another example, it is noted herein that the memory 136 is configured to store one or more results from the system 100 and/or the output of the various steps described herein. It is further noted that memory 136 may be housed in a common controller housing with the one or more processors 138. In an alternative example, the memory 136 may be located remotely with respect to the physical location of the processors and controller 134. For instance, the one or more processors 138 of controller 134 may access a remote memory (e.g., server), accessible through a network (e.g., Internet, intranet and the like). In another example, the memory 136 stores the program instructions for causing the one or more processors 138 to carry out the various steps described throughout the present disclosure.

All of the methods described herein may include storing results of one or more steps of the method examples in a storage medium. The results may include any of the results described herein and may be stored in any manner known in the art. The storage medium may include any storage medium described herein or any other suitable storage medium known in the art. After the results have been stored, the results can be accessed in the storage medium and used by any of the method or system examples described herein, formatted for display to a user, used by another software module, method, system, or the like. Furthermore, the results may be stored "permanently," "semi-permanently," temporarily, or for some period of time. For example, the storage medium may be random access memory (RAM), and the results may not necessarily persist indefinitely in the storage medium.

In another example, the controller 134 of the system 100 may be configured to receive and/or acquire data or information from other systems by a transmission medium that may include wireline and/or wireless portions. In another example, the controller 134 of the system 100 may be configured to transmit data or information (e.g., the output of one or more processes disclosed herein) to one or more systems or sub-systems by a transmission medium that may include wireline and/or wireless portions. In this manner, the transmission medium may serve as a data link between the controller 134 and other subsystems of the system 100. Moreover, the controller 134 may send data to external systems via a transmission medium (e.g., network connection).

In another example, the system 100 includes a user interface. In one example, the user interface is communicatively coupled to the one or more processors 138 of controller 134. In another example, the user interface device may be utilized by controller 134 to accept selections and/or instructions from a user. In some examples, described further herein, a display may be used to display data to a user (not shown). In turn, a user may input, via user input device, a selection and/or instructions responsive to data displayed to the user via the display device.

The user interface device may include any user interface known in the art. For example, the user input device of the user interface may include, but is not limited to, a keyboard, a keypad, a touchscreen, a lever, a knob, a scroll wheel, a track ball, a switch, a dial, a sliding bar, a scroll bar, a slide, a handle, a touch pad, a paddle, a steering wheel, a joystick, a bezel input device or the like. In the case of a touchscreen interface device, those skilled in the art should recognize that a large number of touchscreen interface devices may be suitable for implementation in the present disclosure. For instance, the display device may be integrated with a touchscreen interface, such as, but not limited to, a capacitive touchscreen, a resistive touchscreen, a surface acoustic based touchscreen, an infrared based touchscreen, or the like. In a general sense, any touchscreen interface capable of integration with the display portion of a display device is suitable for implementation in the present disclosure.

The display device may include any display device known in the art. In one example, the display device may include, but is not limited to, a liquid crystal display (LCD). In another example, the display device may include, but is not limited to, an organic light-emitting diode (OLED) based display. In another example, the display device may include, but is not limited to, a CRT display. Those skilled in the art should recognize that a variety of display devices may be suitable for implementation in the present disclosure and the particular choice of display device may depend on a variety of factors, including, but not limited to, form factor, cost, and the like. In a general sense, any display device capable of integration with a user input device (e.g., touchscreen, bezel mounted interface, keyboard, mouse, trackpad, and the like) is suitable for implementation in the present disclosure.

As shown, the busway 122 may receive electrical power from a power input 140 (e.g., electrical conductors such as cables, terminals, plates, or the like). For example, the six or more electrical conductors may be routed from a PDU 118 or any other component of the powertrain 130 to an end of the busway 122. The six or more electrical conductors may include six phase conductors corresponding to the six-phase power distribution, wherein each conductor may carry one phase of the six-phase system. In examples utilizing seven electrical conductors, the additional conductor may serve as a neutral return path. In examples utilizing eight electrical conductors, two conductors may be configured as neutral conductors, which may provide redundancy or may be configured to handle imbalanced loads between different phase pairs. The power input 140 may include terminal blocks, lug connections, or bolted bus connections configured to accommodate the higher conductor count compared to traditional three-phase systems. The routing of six or more electrical conductors from the PDU 118 may require specialized cable tray configurations or conduit sizing to accommodate the increased conductor count while maintaining required separation distances for electrical safety and heat dissipation. The busway 122 may provide the power via power output 142.

The powertrain 130 may include a transformer 150 configured to convert three-phase power to six-phase power. The transformer 150 may be positioned at various locations within the powertrain 130 to facilitate the conversion from three-phase to six-phase power distribution, or any other suitable phase power conversion. For example, the transformer 150 may be integrated within the PDU 118, mounted adjacent to the PDU 118, or positioned at any intermediate point between the power source 102 and the busway 122. The transformer 150 may include a three-phase primary winding configuration and a six-phase secondary winding configuration. For instance, the transformer 150 may employ a double-delta or double-wye secondary winding arrangement to generate six output phases from a three-phase input. By way of another example, the transformer 150 may include a primary delta configuration coupled to dual secondary wye configurations, wherein the two secondary wye configurations are phase-shifted by 30 electrical degrees relative to each other. The transformer 150 may alternatively be configured to generate two separate three-phase outputs that collectively approximate a six-phase power source, which may be referred to as a hybrid three-phase configuration. For example, the transformer 150 may include dual three-phase secondary windings, wherein a first three-phase secondary winding provides phases at 0, 120, and 240 degrees, and a second three-phase secondary winding provides phases at 30, 150, and 270 degrees. For instance, when these two three-phase systems are combined at the busway 122 input, they may effectively create a six-phase distribution system with 60-degree phase separation between adjacent phases. However, note that this is a nonlimiting example and that the transformer 150 may include any type of transformer configuration suitable for converting three-phase power to six-phase power or for generating multiple phase-shifted three-phase outputs that approximate six-phase power distribution.

In examples, any number and sequence of hybrid three-phase, full six-phase, or other phase configurations may be used along any length of the powertrain. For example, a three-phase input may be converted to a six-phase output using a transformer, then after such power travels through one or more components of the powertrain may be converted to a hybrid three-phase approximating a six-phase power, and then later converted back, or the like. Such changing of phase configurations may allow for utilizing select phases at select stages of the powertrain, which may improve efficiency and provide interoperability with existing components, such as components configured for six-phase, hybrid three-phase, and/or three-phase.

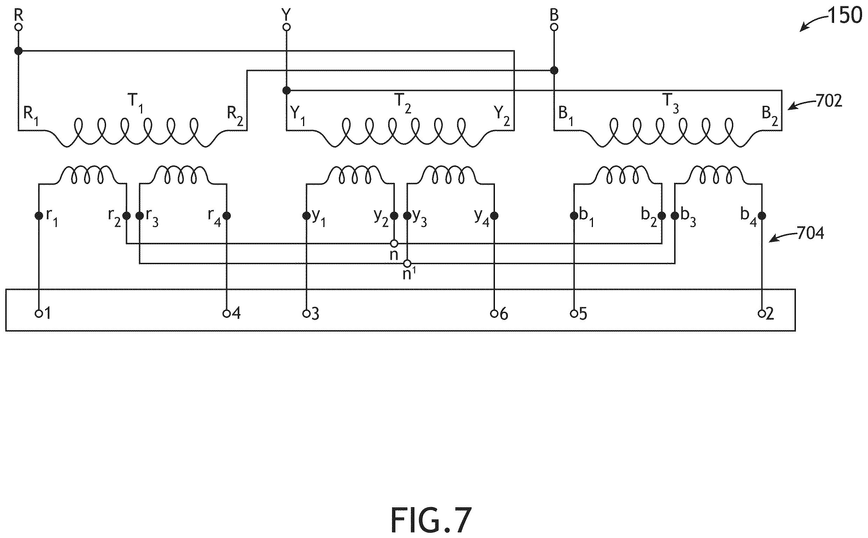

In examples, a system 100 for power distribution in a data center 132 may include a transformer 150 configured to convert three-phase electric power to six-phase electric power. The transformer 150 may be configured to be disposed proximate to a source of power (e.g., PDU 118, or any other component of the powertrain 130). The transformer 150 may include secondary windings (see FIG. 7, secondary windings 702) comprising at least six current carrying conductors (e.g., transformer cable windings coupled to lugs, cables, busbars, or the like).

The source of power may include a floor power distribution unit (PDU) 118.

The at least six current carrying conductors of the secondary windings 702 may be configured to be distributed to one or more racks 126 housing one or more rack appliances 128 via at least one of: one or more busways 122; or one or more insulated electrical cables (e.g., cables of a RPP 120). The at least one of the one or more busways 122 or the one or more insulated electrical cables may be configured to be utilized to provide poly-phase power to power supply inputs of the one or more rack appliances 128.

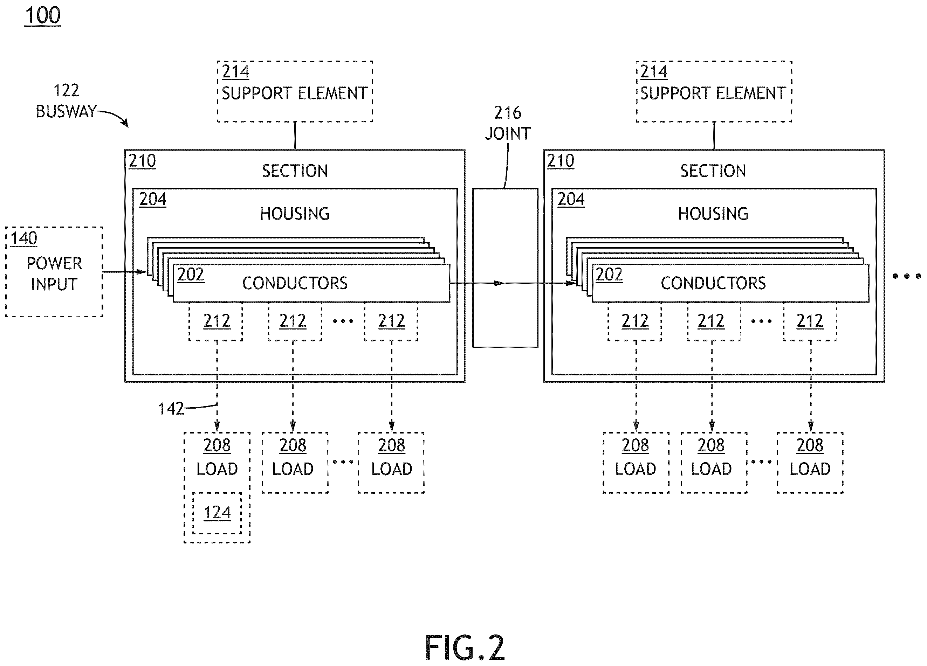

FIG. 2 illustrates a schematic block diagram of a system 100 including the busway 122 configured for six phase power, in accordance with one or more examples of the present disclosure.

The busway 122 may include one or more busway sections 210. For example, the sections 210 may be straight and may be joined end-to-end by joints 216. The joints 216 may be any suitable shape to allow for straight alignment of sections 210 and/or angled alignment (e.g., 90-degree bend).

Each busway section 210 may include a housing 204. For example, the housing may at least partially enclose internal conductors (e.g., busbars 202).

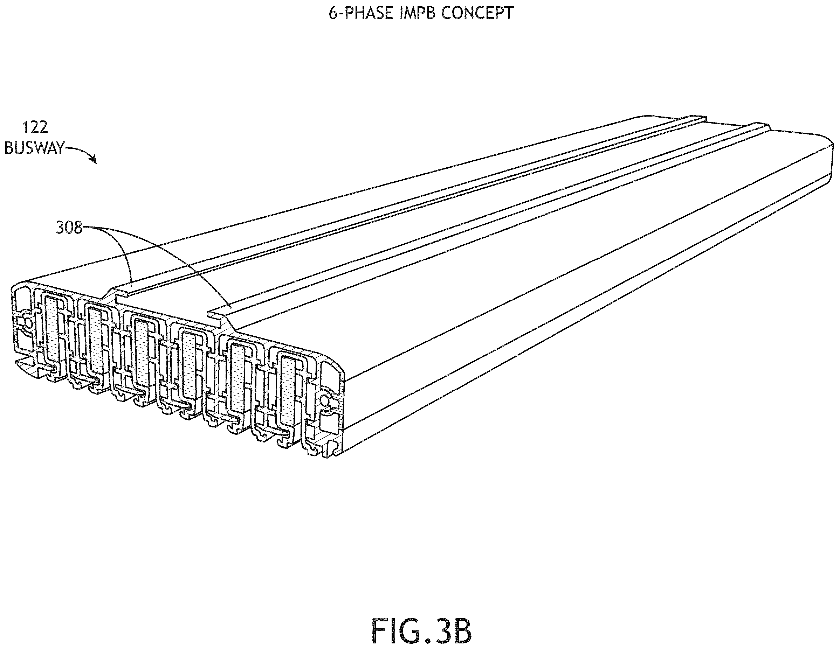

The housing 204 may include a corresponding surface configured to receive a support element 214 (e.g., overhead bracket). The support element 214 may be configured to suspend the busway 122 in an overhead configuration of a data center 132. See FIG. 3B for an example of a corresponding surface 308 configured to receive the support element 214. For example, the corresponding surface 308 may include a protrusion and/or recess, such as a slot, hole, ridge, groove, and/or the like. For example, the corresponding surface 308 may include two opposing protrusions defining opposing grooves configured to receive corresponding edges of a support element 214 (e.g., bracket or tabs that slide under the protrusions).

Each busway section 210 may include a plurality of busbars 202 spaced apart in a first direction. The first direction may be referred to as a stacked direction, and may be horizontal or vertical, depending on the busway orientation and the insertion direction of the output connectors. Each busbar 202 of the plurality of busbars 202 may be disposed along a second direction perpendicular to the first direction and may be parallel to each other busbar 202 of the plurality of busbars 202. In examples, the second direction may include any direction, but typically is horizontal.

Each busway section 210 may be configured to be removably coupled to two or more output connectors 212 (e.g., tap-off boxes, whips, or the like) at two or more locations couplable along the second direction. The two or more output connectors 212 may be configured to be inserted from a third direction perpendicular to the first direction and the second direction. For example, the third direction may be vertically from below or horizontally from the side.

Each output connector 212 may be configured to couple to a load 208 (e.g., electrical load such as a rack PDU 124, compute devices, or the like).

The plurality of busbars 202 may be at least partially enclosed by the housing 204. For example, the housing 204 may wrap around three or more sides of the busbars 202, leaving one side open for coupling.

The plurality of busbars 202 may include six or more busbars 202 and may thereby be configured for the six phase power. However, note that the plurality of busbars 202 may include any suitable number of busbars 202, with any suitable numbers of additional busbars 202 for neutral, wired communications, and/or the like.

For example, the plurality of busbars 202 may include seven or more busbars 202 including a first neutral busbar of the plurality of busbars 202.

By way of another example, the plurality of busbars 202 may include eight or more busbars 202 including a first neutral busbar and a second neutral busbar of the plurality of busbars 202.

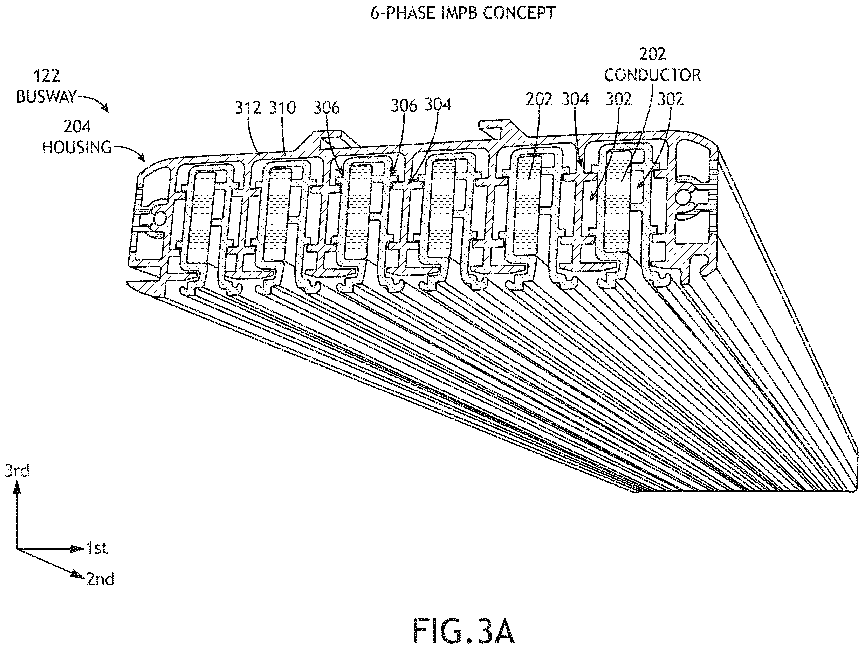

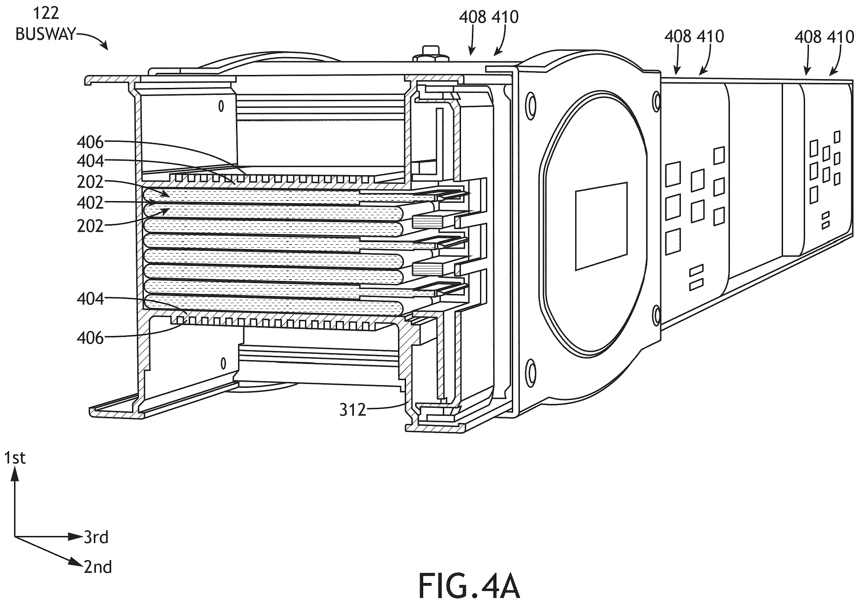

FIGS. 3A through 3C disclose a busway with isolated conductors exposed along their length, providing continuous adjustability as to where to couple to the busway, while FIGS. 4A through 4F disclose a busway with discrete coupling interfaces that limit coupling to a plurality of discrete locations. However, note that the busways 122 described herein are non-limiting examples and any suitable busway 122 configured for six phase power in any suitable configuration, shape, size, or the like may be used.

FIG. 3A illustrates a perspective cross-sectional view of a busway 122 in an isolated-phase configuration, in accordance with one or more examples of the present disclosure. For example, the isolated-phase configuration may include or be categorized as an Isolated Modular Power Busway (iMPB). In examples, the isolated-phase configuration may allow couplers (e.g., tap-off boxes, whips, or the like) to be coupled at any location, with continuous adjustability, along the length of the busway 122. However, in some examples, even in an isolated-phase configuration, the number of locations to couple with the busway may be finite, such as limited by notches or the like at discrete intervals.

In some examples, the plurality of busbars 202 are in an isolated-phase configuration such that each busbar 202 of the plurality of busbars 202 is individually physically isolated from each adjacent busbar 202. For example, each busbar 202 of the plurality of busbars 202 may be individually physically isolated from each adjacent busbar 202 by at least one of: one or more respective airgaps 302; or a respective cell wall 304 (e.g., divider wall) of the housing 204. Each respective cell wall 304 may be configured to be electrically grounded, such as by being formed of an electrically conductive material and being electrically coupled to a common groundable element (e.g., top plate 310). In examples, a body 312 of the housing may include the top plate 310 and the cell walls 304. The body 312 may include a consistent cross-sectional area along an entire length, which may allow it to be manufactured using extrusion methods or the like.

Each busbar 202 may be further electrically insulated from adjacent cell walls 304 by an electrically-insulating element 306 surrounding at least three sides of each busbar 202. The electrically-insulating element 306 may be configured to receive a portion (e.g., blade) of an output connector 212 via a gap or the like. For example, a gap of the electrically-insulating element 306 may align with a gap between adjacent cell walls 304, so that a blade of a tap-off device (or any other coupling element) may be inserted and couple with the busbar 202. The gap may be bare (e.g., exposed to an external environment at all times) or shuttered (e.g., covered when not in use by a shutter (not shown)).

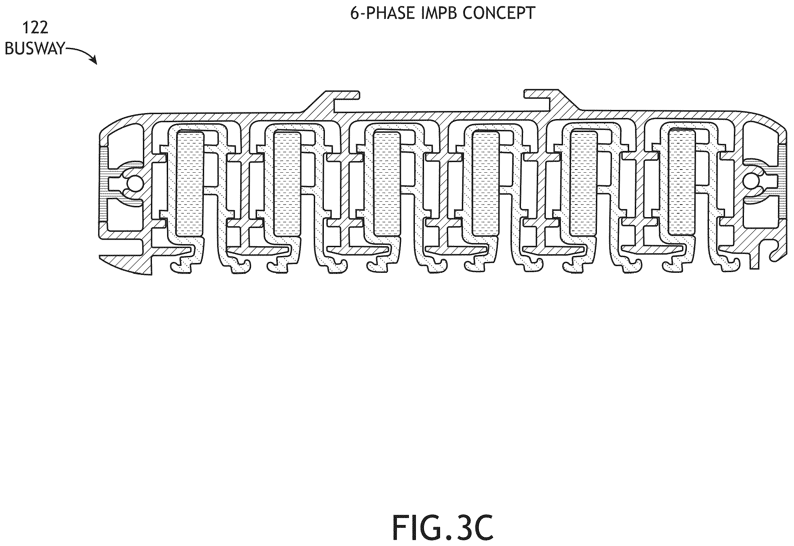

FIGS. 3B and 3C illustrate alternate perspective cross-sectional views of the busway 122 in the isolated-phase configuration of FIG. 3A, in accordance with one or more examples of the present disclosure.

FIG. 4A illustrates a perspective cross-sectional view of a busway 122 in a sandwiched configuration, in accordance with one or more examples of the present disclosure. The sandwiched configuration may allow coupling to the busway 122 at discrete locations 408.

In some examples, the plurality of busbars 202 are in a sandwiched configuration such that each busbar 202 of the plurality of busbars 202 is sandwiched adjacent to, except for one or more solid layers, at least one adjacent busbar 202 of the plurality of busbars 202. The one or more solid layers may include one or more solid electrically-insulating layers 402 configured to prevent electrical coupling, one or more layers configured to prevent rust (e.g., paint), one or more adhesive layers (e.g., glue), and/or the like. However, the one or more solid layers may be thermally conductive such that the busbars 202 are in thermal communication (e.g., configured to pass heat between each other). In some examples, a total thickness of the one or more solid layers between any two busbars 202 is less than a thickness of a single busbar 202.

Each of the two or more locations 408 along the second direction that is configured to be removably coupled to an output connector 212 may be a discrete, separate location and may include a discrete busway output interface 410.

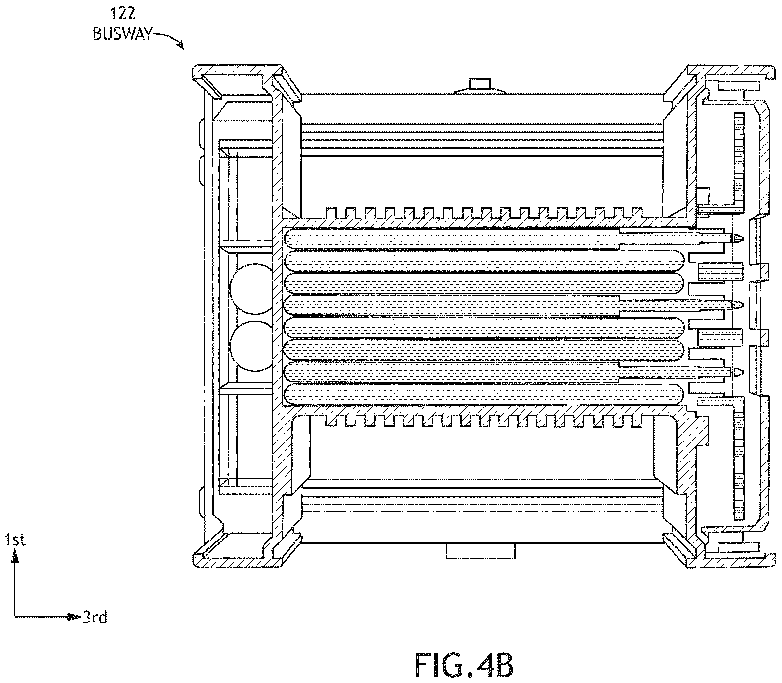

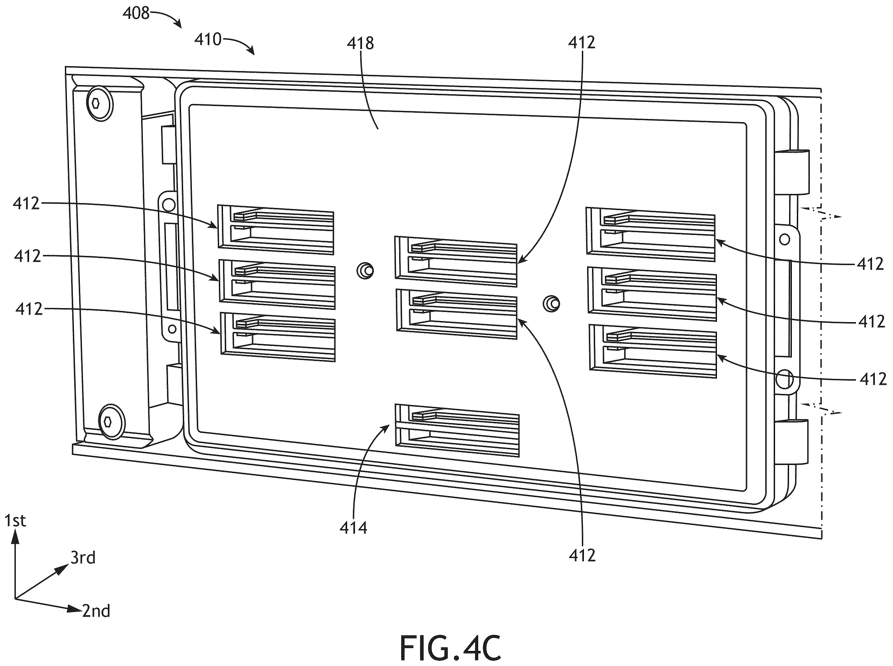

FIG. 4B illustrates an end cross-sectional view of the busway 122 in the sandwiched configuration, in accordance with one or more examples of the present disclosure. FIG. 4C illustrates an enlarged perspective view of a busway output interface 410 of the busway 122 in the sandwiched configuration, in accordance with one or more examples of the present disclosure.

Each busway output interface 410 may include six or more individual terminals 412 (e.g., separated ports, orifices, couplable connections). For example, each busway output interface 410 may include seven or more, or eight or more individual terminals 412. Each individual terminal 412 may be electrically coupled to, and aligned with, a corresponding busbar 202 of the plurality of busbars 202. Each individual terminal 412 may be configured to receive a corresponding conducting element (e.g., blade, pin, couplable connection, or the like) of an output connector 212 (e.g., tap-off box). The busway output interface 410 may include a non-conducting outward-facing surface 418 (e.g., cover plate) defining and separating the individual terminals 412. Any portion of the busbars 202, besides the terminals 412, may be covered by plates, paint, or the like to prevent accidental electrical shock. In some examples, the terminals 412 themselves may be shuttered for safety.

The six or more individual terminals 412 may be arranged in any suitable arrangement. In some examples, the six or more individual terminals 412 are arranged in three or more columns. Each column may be spaced apart from adjacent columns in the second direction. Each terminal 412 of a particular column may be spaced apart from adjacent terminals 412 in the first direction (e.g., vertically).

For example, as shown, each terminal 412 of a particular column may be coupled to a first busbar that is offset by three positions (i.e., with two intervening busbars) from another busbar coupled to an adjacent terminal 412 of the same column. This three-position offset arrangement may not be achievable in three-phase systems.

The three-position offset arrangement may be uniquely enabled by the increased busbar count in six-phase configurations. For instance, this spacing may provide enhanced electrical isolation between terminals 412 within a single column, reducing the risk of arcing during hot-swapping operations when output connectors 212 are inserted or removed while the busway 122 is energized. The increased physical separation between energized terminals 412 in the same column may allow for larger terminal contact areas, which may reduce contact resistance and associated heating at the connection points. Furthermore, this arrangement may enable the use of more robust insulation barriers between terminals 412, improving safety margins for maintenance personnel. The staggered configuration may also facilitate more efficient heat dissipation by distributing thermal hotspots across different vertical positions rather than concentrating them near the same adjacent heights. Additionally, the three-position offset may provide mechanical benefits by distributing insertion forces across different busbar levels when an output connector 212 is coupled to the busway output interface 410, potentially reducing mechanical stress on individual busbars 202 and their supporting structures.

For example, as shown and in order, the terminals 412 of a first column may be coupled to a first (e.g., top) busbar, fourth busbar, and seventh busbar. The terminals 412 of a different column (e.g., third column) may be coupled to a second busbar, fifth busbar, and eighth busbar. The terminals 412 of another column (e.g., second column) may be coupled to a third busbar, and sixth busbar. This configuration may provide benefits such as maximally spaced terminals 412 in a three-column, eight-or-more terminal configuration. This may allow for closer busbars (e.g., thinner, more compact busbar sandwich designs).

As shown in FIG. 4C, the phases of the terminals and/or busbars may be as follows: first column first (e.g., top) busbar = L3, fourth busbar = L3O, and seventh busbar = N (e.g., neutral). The terminals 412 of a different column (e.g., third column) may be second busbar = N (e.g., neutral), fifth busbar = L1, and eighth busbar = L1O. The terminals 412 of another column (e.g., second column) may be third busbar = L2, and sixth busbar L2O. Throughout the present disclosure, "O", such as L1O, means "opposite phase" or "180 degrees offset within each pair of Lx/LxO". In this way, L1/L1O, L2/L2O, and L3/L3O collectively provide six phases. The two Ns, may be neutrals or the like.

In examples, each busway output interface 410 may include an additional terminal 414, such as to be configured as a protective earthing (PE) terminal. For example, the additional terminal 414 may be electrically coupled to the housing 204 (e.g., body 312), not the plurality of busbars 202. In another example, the additional terminal 414 may be coupled to an additional busbar (e.g., tertiary PE busbar). The additional terminal 414 may be configured as a first-make/last-break terminal, such that the additional terminal 414 is configured to make electrical contact with the output connector 212 first when being coupled and to break electrical connection last when being decoupled. For example, the additional terminal 414 may be a different shape than the other terminals 412. For example, the additional terminal 414 may include a relatively shallower hole or the like so electrical contact is configured differently to ensure the desired first-make/last-break behavior.

In examples, a top and a bottom busbar of the plurality of busbars 202 may each be coupled to a heatsink 404 of the housing 204. Each heatsink 404 may span at least a portion of a width of the plurality of busbars 202 along the third direction. Each heatsink 404 may include a plurality of outward-protruding fins 406 that may be configured to dissipate heat.

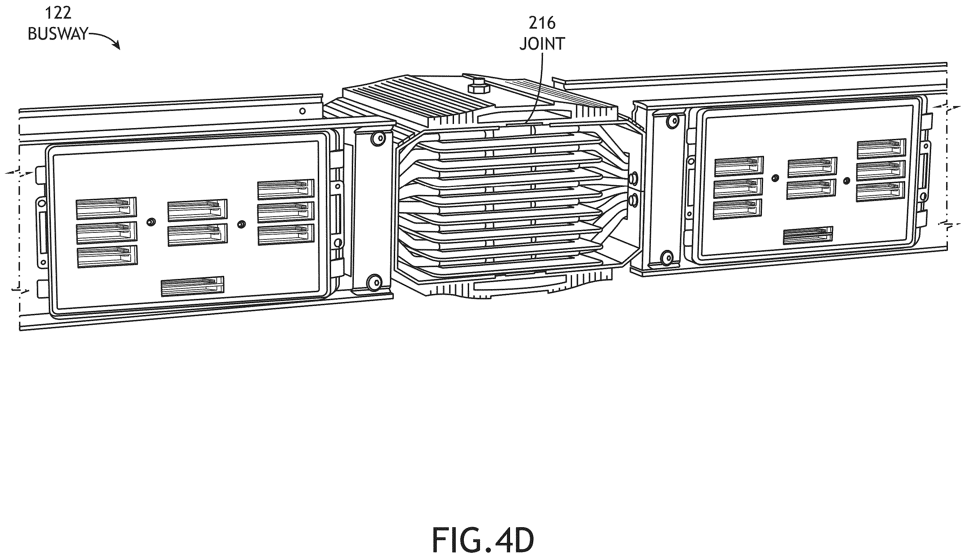

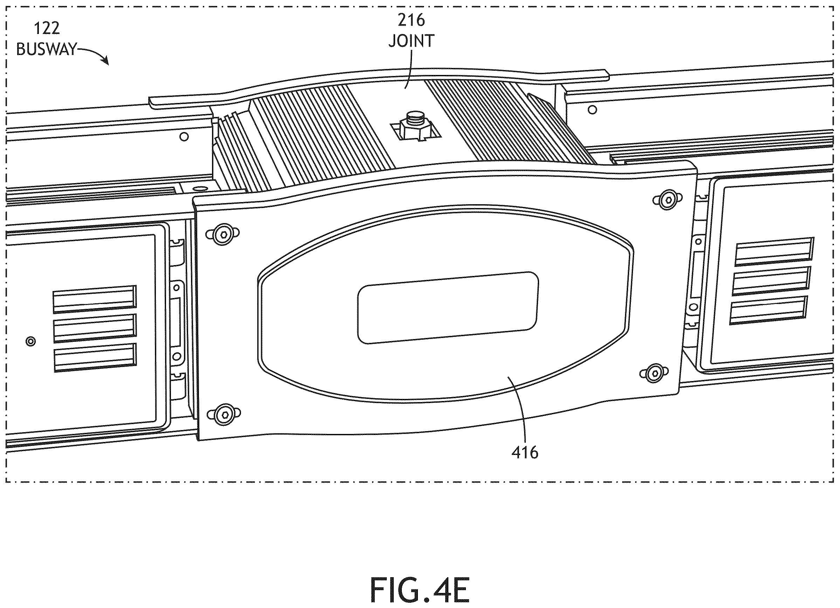

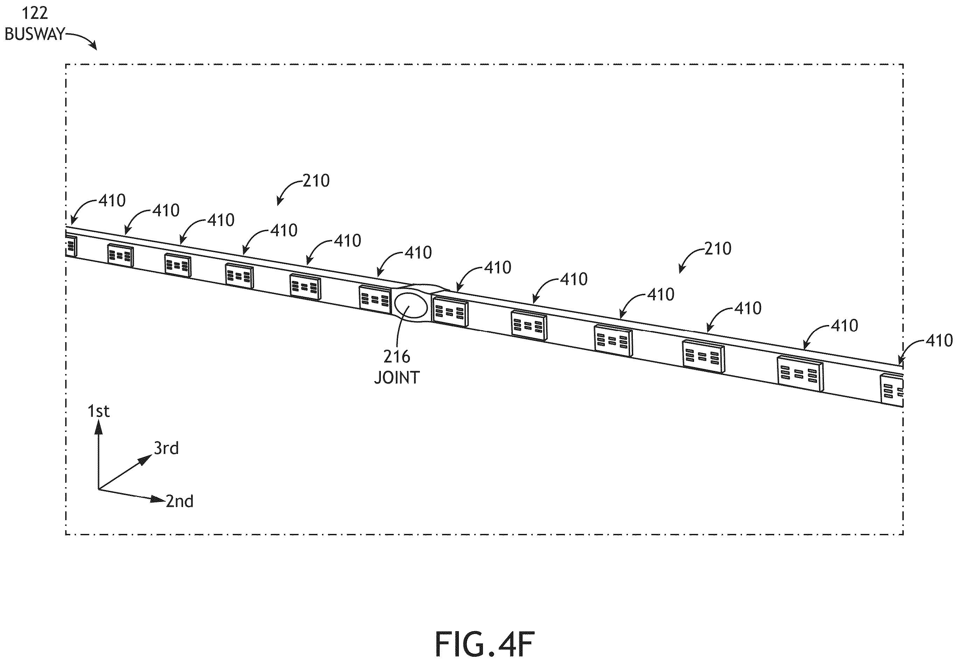

FIG. 4D illustrates a perspective view of a busway output interface 410 on each side of a joint of the busway 122 in the sandwiched configuration, in accordance with one or more examples of the present disclosure. FIG. 4E illustrates a perspective view of a cover 416 of the joint 216 of the busway 122 in the sandwiched configuration, in accordance with one or more examples of the present disclosure. FIG. 4F illustrates a zoomed-out perspective view of the busway 122 in the sandwiched configuration, in accordance with one or more examples of the present disclosure.

As shown in FIG. 4F, any number of busway output interfaces 410 may be used, such as six or more busway output interfaces 410 per section 210.

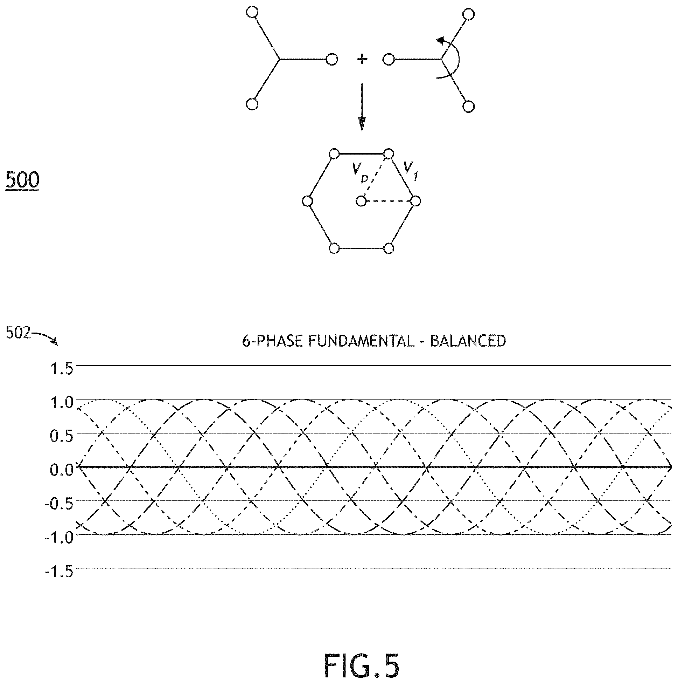

FIG. 5 illustrates a diagram 500 of an electrical configuration and a waveform 502 of the busway 122, in accordance with one or more examples of the present disclosure.

As illustrated by the phasor diagram 500 and the balanced sinusoidal waveforms 502, the busbars 202 may be configured for six phase voltages that are equal-magnitude sinusoids separated by 60 degrees with paired 180-degree counterparts (e.g., X/X0, Y/Y0, Z/Z0), forming a regular hexagonal set that yields near-zero neutral current under balanced loading and enables reduced ripple for multi-pulse rectification. The phasor diagram 500 may illustrate two three-phase star configurations that collectively provide the six-phase power distribution, wherein the two star configurations may be phase-shifted relative to each other by 30 electrical degrees. When combined, these two three-phase systems may create the hexagonal phasor arrangement shown, wherein each phase pair may maintain 180-degree opposition while the three phase pairs may be displaced by 120 degrees from each other. This configuration may result in each adjacent phase being separated by 60 electrical degrees. The waveforms 502 may demonstrate that at any given instant in time, the vectorial sum of all six phase currents may approach zero under balanced load conditions, which may substantially reduce or eliminate neutral current flow through the neutral busbars.

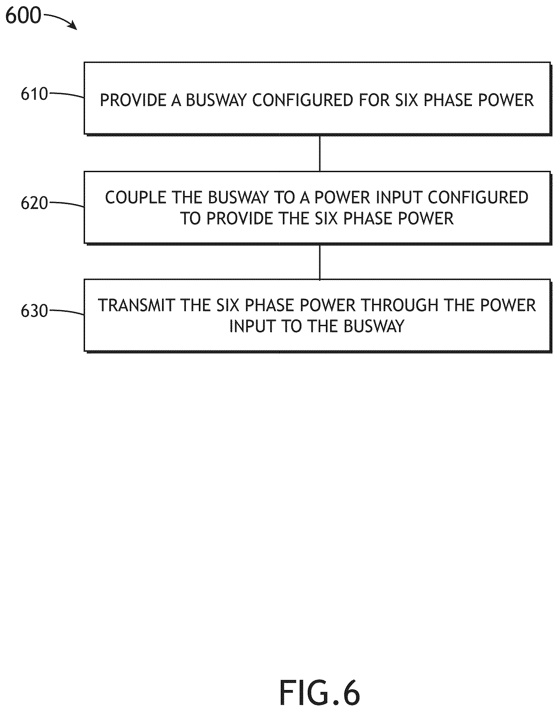

FIG. 6 illustrates a flow diagram depicting a method 600 for providing a busway 122 configured for six phase power, in accordance with one or more examples of the present disclosure. It is noted that the examples and enabling technologies described previously herein in the context of the system 100 should be interpreted to extend to the method 600. It is further noted herein that the steps of method 600 may be implemented all or in part with system 100. It is further recognized, however, that the method 600 is not limited to the system 100 in that additional or alternative system-level examples may carry out all or part of the steps of method 600.

At step 610, a busway 122 configured for six phase power may be provided. The busway 122 may include one or more busway sections 210. Each busway section 210 may include a housing 204. Each busway section 210 may include a plurality of busbars 202 spaced apart in a first direction. The plurality of busbars 202 may include six or more busbars 202 and may thereby be configured for the six phase power. The plurality of busbars 202 may be at least partially enclosed by the housing 204. Each busway section 210 may be configured to be removably coupled to two or more output connectors 212.

At step 620, the busway 122 may be coupled to a power input 140 configured to provide the six phase power. For example, the busway 122 may be coupled to any component of the powertrain 130, such as a PDU 118.

At step 630, the six phase power may be transmitted through the power input 140. For example, the entire power in the data center 132 may be turned on (e.g., activated) via controller 134. In this way, the six phase power may be transmitted from the power input 140 through the busway 122.

As described, for floor and rack mounted PDU supporting the high-power demands of PSU within or coupled to computer servers used for HPC and/or AI workload processing, conventional higher ampacity three-phase distribution systems are typically used for power distribution. However, the distribution and termination of large cross-sectional area of current-carrying conductors and the safety requirements for minimum functional insulation spacing between proximate exposed bare conductors and termination elements are limiting factors in power density and constructions of the distribution and supporting equipment enclosures (e.g., such as in a system where 240/415Vac service required to deliver 200kVA and above).

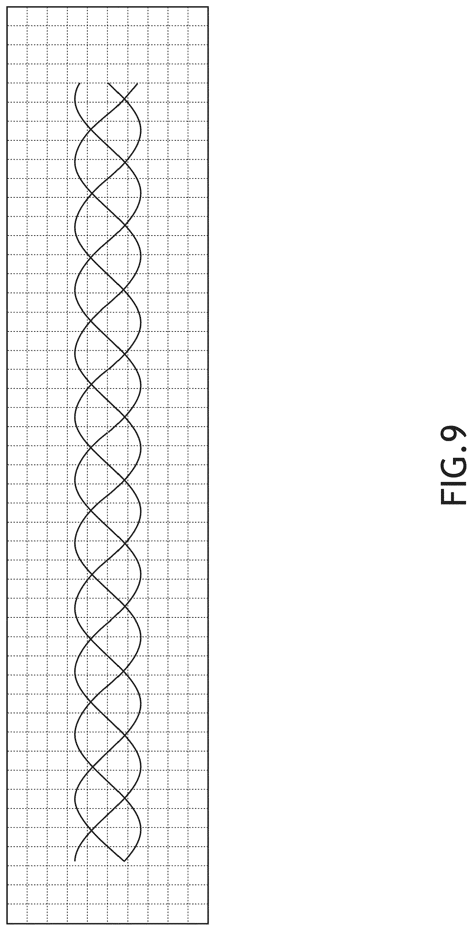

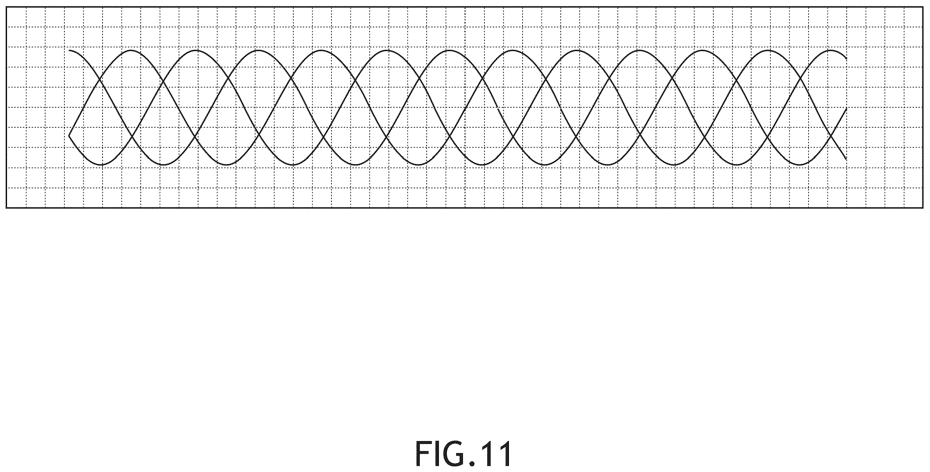

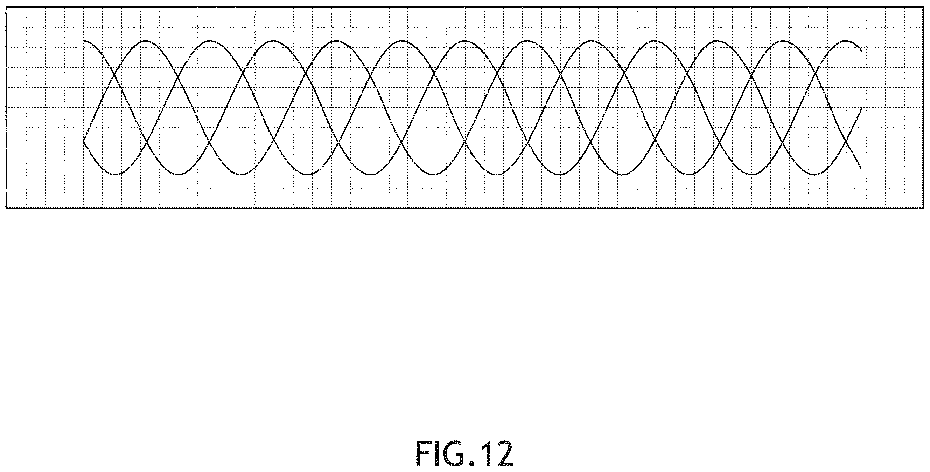

FIGS. 7 through 13 relate to using six phase power in a datacenter, such as near a floor PDU, according to one or more examples of the present disclosure.

Systems and methods configured to provide high phase order power distribution in a datacenter may be desirable. In some examples, the systems and methods described herein may be configured to use a high phase order (HPO) PDU system configured to distribute at least six current-carrying conductors (e.g., with or without neutral) configured for six-phase power for greater power density compared to a three-phase system. Additionally, or alternatively, the systems and methods described herein may be configured to use proportionally reduced functional insulation spacings and smaller cross-sectional area of current-carrying conductors to provide power transfer equivalency.

Note that being configured for six-phase power may mean being configured for full six-phase power, and/or being configured for hybrid three-phase power. Hybrid three-phase power may include being configured to transmit two separate three-phase outputs that collectively approximate a six-phase power source. In examples, any number and sequence of hybrid three-phase, full six-phase, or other phase configurations may be used along any length of the powertrain, such as the PDU 118. For example, a three-phase input may be converted to a six-phase output using a transformer 150, then after such power travels through one or more components of the powertrain may be converted to a hybrid three-phase approximating a six-phase power, and then later converted back, or the like. Such changing of phase configurations may allow for utilizing select phases at select stages of the powertrain, which may improve efficiency and provide interoperability with existing components, such as components configured for six-phase, hybrid three-phase, and/or three-phase.

For a six-phase PDU system the electric field strength between current-carrying conductors electrically displaced by 60° may be 1.73 times less compared to 120° three-phase system, resulting in a line voltage being equivalent to the phase voltage (e.g., which may be represented by the formulas and calculations described herein). Therefore, the minimum required separation of parallel adjacent 60° out-of-phase conductors and termination elements may be based on a lower working voltage. As such, the systems and methods described herein may be configured to provide an increased (e.g., up to 73% or other suitable value) greater power density for same cross-sectional area current-carrying conductors and functional insulation spacing, while utilizing elevated six-phase voltage equivalent to three-phase line voltage (e.g., while conforming to electrical code and applicable safety standards).

For comparable scale of three-phase power delivery, a high-phase PDU system (e.g., six-phase) converted from a three-phase source using a transformer 150, (e.g., double star type transformer, as is illustrated in FIG. 7, or any other suitable transformer), standalone or located within the floor PDU 118, can reduce the unit cross-sectional size, weight, and cost of conductor at the point of distribution and termination. This may benefit the design and construction efficiencies for many components, including multi-conductor power whips, busway structure and adjoining elements, terminal blocks, overhead and rack PDU busway volume for allowances for landing strain relief and accommodating cable bend radius, reduction of voltage and current sensing elements, size of overcurrent protection devices (OCPD) protecting the receptacles, and/or the like. Additionally, or alternatively, six-phase power distribution may provide a combination of low voltage (e.g., less than 600V) poly-phase distribution options at the rack PDU for both information technology (IT) and compute equipment having disparate input voltage of PSU by utilizing both oblique and cross-phase conductors, (e.g., for a 240/415Vac service, nominally 240Vac, 415Vac, and 480Vac are configurable; for 277/480Vac service, nominally 277Vac, 480Vac, and 554Vac are configurable).

The transformer 150 may include primary windings 702 positioned proximate to secondary windings 704. For example, the secondary windings 704 may include at least six current carrying conductors (e.g., electrically conducting material such as cables, or the like) configured to carry six-phase power.

In some examples, the systems and methods described herein may be configured to, for energy metering at the rack PDU for a suitable three-phase four wire receptacle, (e.g., 480V NEMA L16-20R), use a lesser three voltage and current sensing elements (e.g., for reduced computational resources, lower cost, and increased space savings). The systems and methods described herein may be configured to use the impedance of the six-phase transformer 150 for reducing downstream short-circuit fault currents.

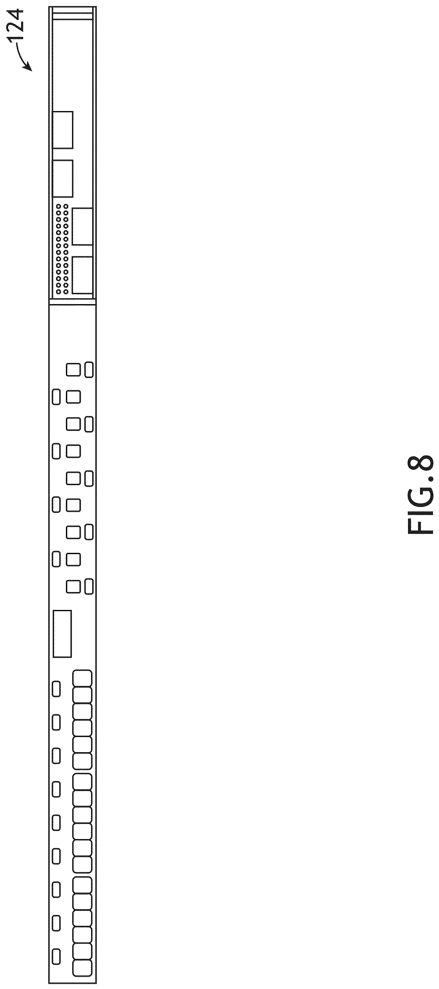

In some examples, the systems and methods described herein may be configured to provide thermal performance benefits compared to a 100kVA rack PDU reference design (e.g., as is illustrated in FIG. 8), which may result in a greater than -10°C temperature reduction measured at the 20A OCPD case compared to the 30A OCPD case under respective full loading conditions, while operating within a 60°C ambient environment (e.g., in the datacenter hot aisle).

Additionally, or alternatively, the systems and methods described herein may be configured to use thermal interface material (TIM) treatment between OCPD case and chassis or internal metal structure for heat sinking (e.g., which may provide a -8°C temperature reduction). The systems and methods described herein may be configured to use smaller cross-sectional current carrying conductors to retain comparable power transfer as three-phase but using elevated phase voltages taking advantage of the greater power density (e.g., relative to lower current-rated OCPD), producing less Joule heating ($I^2R$) accordingly. This may obviate the need for TIM, to provide lower cost and less complicated construction.

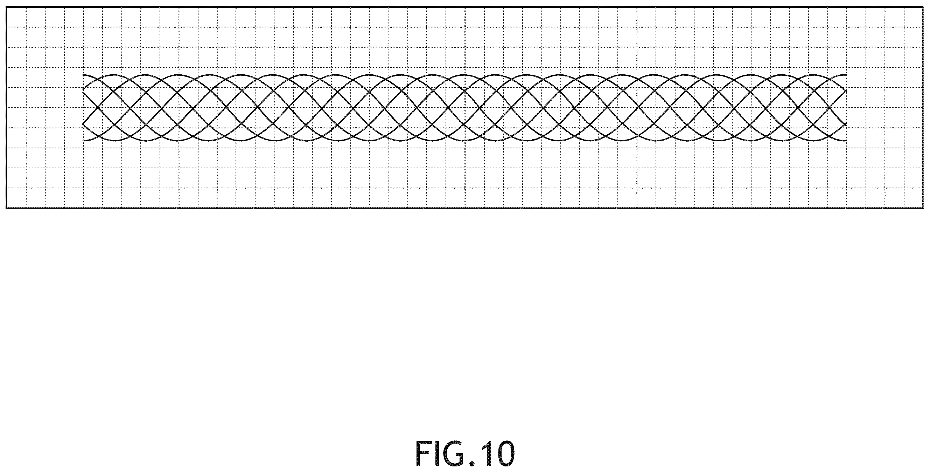

In some examples, the systems and methods described herein may be configured to change three-phase power service from 240/415Vac to 330/575Vac using a newly configured UPS to provide an increase (e.g., 44%) in power transfer capability compared to a lower expenditure relative to converting the floor PDU output for six-phase 240/415Vac distribution to provide an increase (e.g., 73% or other suitable value) in power transfer capability. Additionally, or alternatively, six-phase distribution provides alternative higher power density solutions for HPC/AI white space for power conversion equipment operating over a wide range of low voltage input, (e.g., 220Vac < V < 600Vac for Open Compute (OCP) compliant power shelves). In some examples, up to six combinations of two-phase line service, two combinations of 120° three-phase service, and single 180° split-phase service may be available at the rack PDU to provide greater compatibility for a variety of voltage input requirements for power conversion equipment sharing the same rack space. These line configurations are illustrated in FIGS. 10 through 12. In some examples, the systems and methods described herein may be configured to provide a reduction (e.g., 25% or other suitable value) in volume of components configured to distribute power by virtue of a reduction in functional insulation spacing and/or cross-sectional area of current-carrying conductors while utilizing elevated phase voltages. The phase voltages may be defined accordingly for three-phase systems:

$$V_l = V_p \angle 0° - V_p \angle (-120°) \qquad \text{(Eq. 1)}$$

$$V_l = V_p (1 \angle 0° - 1 \angle (-120°)) \qquad \text{(Eq. 2)}$$

$$V_l = V_p (1 + j0 - (cos(-120°) + j\, sin(-120°))) \qquad \text{(Eq. 3)}$$

$$V_l = V_p (1 + 0.5 + j\, 0.866) \qquad \text{(Eq. 4)}$$

$$|V_l| = |V_p|\, \sqrt{(1.5^2 + 0.866^2)} \qquad \text{(Eq. 5)}$$

$$|V_l| = 1.736 * |V_p| \therefore 1.73 * \textit{Phase voltage} \equiv \textit{Line Voltage} \qquad \text{(Eq. 6)}$$

And accordingly, for six-phase systems, the phase voltages may be defined as follows:

$$V_l = V_p \angle 0° - V_p \angle (-60°) \qquad \text{(Eq. 7)}$$

$$V_l = V_p (1 \angle 0° - 1 \angle (-60°)) \qquad \text{(Eq. 8)}$$

$$V_l = V_p (1 + j0 - (cos(-60°) + j\, sin(-60°))) \qquad \text{(Eq. 9)}$$

$$V_l = V_p (1 - 0.5 + j0.866) \qquad \text{(Eq. 10)}$$

$$|V_l| = |V_p|\, \sqrt{(0.5^2 + 0.866^2)} \qquad \text{(Eq. 11)}$$

$$|V_l| = |V_p| \therefore \text{Phase voltage} \equiv \text{Line Voltage} \qquad \text{(Eq. 12)}$$

In some examples, the systems and methods described herein may be configured to convert three-phase to six-phase power distribution using a suitable transformer near the power source or first stage subfeed circuit splitting (e.g., a floor PDU 118 or other suitable distribution unit). The systems and methods described herein may be configured to distribute the at least six current carrying conductors, including protective earthing (PE) conductor, along an overhead busway or cable tray, to one or more racks containing rack appliances 128 (e.g., IT and compute equipment). The systems and methods described herein may be configured to use one or more rack PDU busways for final stage branch circuit splitting to provide poly-phase power distribution to the equipment power supply inputs. The systems and methods described herein may be configured to exploit the range of configurable voltage outputs and greater power densities achievable through reduction in size and/or number of distribution and termination elements and fewer computational resources required by the rack PDU 124 for energy metering.

In some examples, the systems and methods described herein may be configured to use the HPO technology within the data center gray and/or white space. The systems and methods described herein may be configured to provide six-phase power distribution to achieve higher power density with a compact design of distribution and equipment enclosures. The systems and methods described herein may be configured to allow two extra conductors and respective distribution and termination volume. The rack PDU 124 may include a two-pole or four-pole OCPD at a polyphase receptacle for complete line-ground fault protection.

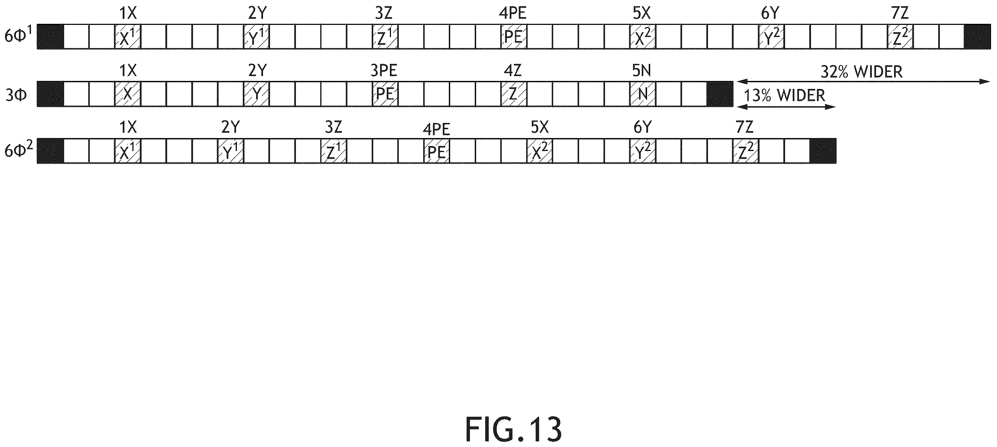

With reference to FIG. 13, a six-phase power distribution can provide up to 73% (e.g., or other suitable value) higher power density by elevating phase voltages for same volume of conductors and insulation spacings. A six-phase power distribution can provide up to 25% (e.g., or other suitable value) reduction of insulation spacing at the same phase voltages for more compact design of distribution and equipment enclosures. The systems and methods described herein may be configured to provide a combination of poly-phase distribution options at the rack PDU 124 for both IT and compute equipment by utilizing both oblique and cross-phase conductors.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "in embodiments/examples", "one embodiment/example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

It is to be understood that examples of the methods disclosed herein may include one or more of the steps described herein. Further, such steps may be carried out in any desired order and two or more of the steps may be carried out simultaneously with one another. Two or more of the steps disclosed herein may be combined in a single step, and in some examples, one or more of the steps may be carried out as two or more sub-steps. Further, other steps or sub-steps may be carried in addition to, or as substitutes to one or more of the steps disclosed herein.

Although inventive concepts have been described with reference to the examples illustrated in the attached drawing figures, equivalents may be employed and substitutions made herein without departing from the scope of the claims. Components illustrated and described herein are merely examples of a system/device and components that may be used to implement examples of the inventive concepts and may be replaced with other devices and components without departing from the scope of the claims. Furthermore, any dimensions, degrees, and/or numerical ranges provided herein are to be understood as non-limiting examples unless otherwise specified in the claims.

Described herein are also the following clauses:

1. A system for power distribution in a datacenter, the system comprising: a transformer configured to convert three-phase electric power to six-phase electric power, the transformer configured to be disposed proximate to a source of power, wherein the transformer comprises: a secondary windings comprising at least six current carrying conductors.

2. The system of clause 1, wherein the source of power comprises a floor power distribution unit.

3. The system of clause 1, wherein the at least six current carrying conductors of the secondary windings are configured to be distributed to one or more racks housing one or more rack appliances via at least one of: one or more busways; or one or more insulated electrical cables, wherein the at least one of the one or more busways or the one or more insulated electrical cables are configured to be utilized to provide poly-phase power to power supply inputs of the one or more rack appliances.

4. A system configured for six phase power, the system comprising: a busway, the busway comprising: one or more busway sections of the busway, each busway section comprising: a housing comprising a corresponding surface configured to receive a support element configured to suspend the busway in an overhead configuration of a data center; and a plurality of busbars spaced apart in a first direction, wherein the plurality of busbars comprise six or more busbars and are thereby configured for the six phase power, wherein the plurality of busbars are at least partially enclosed by the housing, wherein each busbar of the plurality of busbars is disposed along a second direction perpendicular to the first direction and is parallel to each other busbar of the plurality of busbars, wherein each busway section is configured to be removably coupled to two or more output connectors at two or more locations couplable along the second direction, wherein the two or more output connectors are configured to be inserted from a third direction perpendicular to the first direction and the second direction.

5. The system of clause 4, wherein the plurality of busbars comprise seven or more busbars comprising a first neutral busbar.

6. The system of clause 4, wherein the plurality of busbars comprise eight or more busbars comprising a first neutral busbar and a second neutral busbar.

7. The system of clause 4, wherein the plurality of busbars are in an isolated-phase configuration such that each busbar of the plurality of busbars is individually physically isolated from each adjacent busbar of the plurality of busbars by at least one of: one or more respective airgaps; or a respective cell wall of the housing, wherein each respective cell wall is configured to be electrically grounded.

8. The system of clause 7, wherein each busbar is electrically insulated from adjacent cell walls by an electrically-insulating element surrounding at least three sides of each busbar, wherein the electrically-insulating element is configured to receive a portion of an output connector.

9. The system of clause 4, wherein the plurality of busbars are in a sandwiched configuration such that each busbar of the plurality of busbars is sandwiched adjacent to, except for one or more solid layers, at least one adjacent busbar of the plurality of busbars, wherein the one or more solid layers comprise one or more solid electrically-insulating layers.

10. The system of clause 9, wherein each of the two or more locations along the second direction that is configured to be removably coupled to an output connector is a discrete, separate location and comprises a discrete busway output interface, wherein each busway output interface comprises:six or more individual terminals, wherein each individual terminal is electrically coupled to a corresponding busbar of the plurality of busbars, wherein each individual terminal is configured to receive a corresponding conducting element of the output connector.

11. The system of clause 10, wherein the six or more individual terminals are arranged in three or more columns spaced apart in the second direction.

12. The system of clause 9, wherein a top and a bottom of the plurality of busbars are each coupled to a heatsink of the housing, wherein each heatsink spans at least a portion of a width of the plurality of busbars along the third direction.

13. The system of clause 12, wherein each heatsink comprises a plurality of outward-protruding fins configured to dissipate heat.

14. A method comprising: providing a busway configured for six phase power, the busway comprising: one or more busway sections of the busway, each busway section comprising: a housing comprising a corresponding surface configured to receive a support element configured to suspend the busway in an overhead configuration of a data center; and a plurality of busbars spaced apart in a first direction, wherein the plurality of busbars comprise six or more busbars and are thereby configured for the six phase power, wherein the plurality of busbars are at least partially enclosed by the housing, wherein each busbar of the plurality of busbars is disposed along a second direction perpendicular to the first direction and is parallel to each other busbar of the plurality of busbars, wherein each busway section is configured to be removably coupled to two or more output connectors at two or more locations couplable along the second direction, wherein the two or more output connectors are configured to be inserted from a third direction perpendicular to the first direction and the second direction; coupling the busway to a power input configured to provide the six phase power; and transmitting the six phase power through the power input to the busway.

15. The method of clause 14, wherein the plurality of busbars comprise seven or more busbars comprising a first neutral busbar.

16. The method of clause 14, wherein the plurality of busbars comprise eight or more busbars comprising a first neutral busbar and a second neutral busbar.

17. The method of clause 14, wherein the plurality of busbars are in an isolated-phase configuration such that each busbar of the plurality of busbars is individually physically isolated from each adjacent busbar of the plurality of busbars by at least one of: one or more respective airgaps; or a respective cell wall of the housing, wherein each respective cell wall is configured to be electrically grounded.

18. The method of clause 17, wherein each busbar is electrically insulated from adjacent cell walls by an electrically-insulating element surrounding at least three sides of each busbar, wherein the electrically-insulating element is configured to receive a portion of an output connector.

19. The method of clause 14, wherein the plurality of busbars are in a sandwiched configuration such that each busbar of the plurality of busbars is sandwiched adjacent to, except for one or more solid layers, at least one adjacent busbar of the plurality of busbars, wherein the one or more solid layers comprise one or more solid electrically-insulating layers.

20. The method of clause 19, wherein each of the two or more locations along the second direction that is configured to be removably coupled to an output connector is a discrete, separate location and comprises a discrete busway output interface, wherein each busway output interface comprises:six or more individual terminals, wherein each individual terminal is electrically coupled to a corresponding busbar of the plurality of busbars, wherein each individual terminal is configured to receive a corresponding conducting element of the output connector.

## Claims

1. A busway configured for six phase power, the busway comprising:
   one or more busway sections of the busway, each busway section comprising:

   a housing comprising a corresponding surface configured to receive a support element configured to suspend the busway in an overhead configuration of a data center; and
   a plurality of busbars spaced apart in a first direction, wherein the plurality of busbars comprise six or more busbars and are thereby configured for the six phase power, wherein the plurality of busbars are at least partially enclosed by the housing, wherein each busbar of the plurality of busbars is disposed along a second direction perpendicular to the first direction and is parallel to each other busbar of the plurality of busbars, wherein each busway section is configured to be removably coupled to two or more output connectors at two or more locations couplable along the second direction, wherein the two or more output connectors are configured to be inserted from a third direction perpendicular to the first direction and the second direction.

2. The busway of claim 1, wherein the plurality of busbars comprise seven or more busbars comprising a first neutral busbar.

3. The busway of claim 1, wherein the plurality of busbars comprise eight or more busbars comprising a first neutral busbar and a second neutral busbar.

4. The busway of any preceding claim, wherein the plurality of busbars are in an isolated-phase configuration such that each busbar of the plurality of busbars is individually physically isolated from each adjacent busbar of the plurality of busbars by at least one of: one or more respective airgaps; or a respective cell wall of the housing, wherein each respective cell wall is configured to be electrically grounded.

5. The busway of claim 4, wherein each busbar is electrically insulated from adjacent cell walls by an electrically-insulating element surrounding at least three sides of each busbar, wherein the electrically-insulating element is configured to receive a portion of an output connector.

6. The busway of any preceding claim, wherein the plurality of busbars are in a sandwiched configuration such that each busbar of the plurality of busbars is sandwiched adjacent to, except for one or more solid layers, at least one adjacent busbar of the plurality of busbars, wherein the one or more solid layers comprise one or more solid electrically-insulating layers.

7. The busway of claim 6, wherein each of the two or more locations along the second direction that is configured to be removably coupled to an output connector is a discrete, separate location and comprises a discrete busway output interface, wherein each busway output interface comprises:
six or more individual terminals, wherein each individual terminal is electrically coupled to a corresponding busbar of the plurality of busbars, wherein each individual terminal is configured to receive a corresponding conducting element of the output connector.

8. The busway of claim 7, wherein the six or more individual terminals are arranged in three or more columns spaced apart in the second direction.

9. The busway of any one of the claims 6 to 8, wherein a top and a bottom of the plurality of busbars are each coupled to a heatsink of the housing, wherein each heatsink spans at least a portion of a width of the plurality of busbars along the third direction.

10. The busway of claim 9, wherein each heatsink comprises a plurality of outward-protruding fins configured to dissipate heat.

11. A method for six phase power, the method comprising:

providing a busway according to any one of the claims 1 to 10;
coupling the busway to a power input configured to provide the six phase power; and
transmitting the six phase power through the power input to the busway.

12. A system for power distribution in a datacenter, the system comprising:

a transformer configured to convert three-phase electric power to six-phase electric power, the transformer configured to be disposed proximate to a source of power, wherein the transformer comprises:
a secondary windings comprising at least six current carrying conductors; wherein the at least six current carrying conductors of the secondary windings are configured to be distributed to one or more racks housing one or more rack appliances via at least one of busways according to any one of the claims 1 to 10.

13. The system of claim 12, wherein the source of power comprises a floor power distribution unit.

14. The system of any one of the claims 12 to 14, wherein the at least six current carrying conductors of the secondary windings are configured to be distributed to one or more racks housing one or more rack appliances via at least one of:

one or more insulated electrical cables,
wherein the one or more insulated electrical cables are configured to be utilized to provide poly-phase power to power supply inputs of the one or more rack appliances.

FIG.1

FIG.2

6-PHASE IMPB CONCEPT

122
BUSWAY

204
HOUSING

202
CONDUCTOR

312 310 306    306 304    202 304 302 302

202

3rd

1st

2nd

FIG.3A

6-PHASE IMPB CONCEPT

122
BUSWAY

308

FIG. 3B

6-PHASE IMPB CONCEPT

122
BUSWAY

FIG.3C

FIG.4A

FIG.4B

122
BUSWAY

3rd

1st

FIG.4C

FIG.4D

FIG.4E

FIG.4F

EP 4 734 306 A1

EP 4 734 306 A1

500

502

6-PHASE FUNDAMENTAL - BALANCED

FIG.5

600

610 — PROVIDE A BUSWAY CONFIGURED FOR SIX PHASE POWER

620 — COUPLE THE BUSWAY TO A POWER INPUT CONFIGURED TO PROVIDE THE SIX PHASE POWER

630 — TRANSMIT THE SIX PHASE POWER THROUGH THE POWER INPUT TO THE BUSWAY

FIG.6

FIG.7

124

FIG.8

FIG.9

FIG.10

FIG.11

FIG.12

FIG.13

Europäisches
Patentamt

European
Patent Office

Office européen
des brevets

# EUROPEAN SEARCH REPORT

**Application Number**

EP 25 21 1141

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/000975 A1 (HEATH TALIVER BROOKS [US] ET AL) 5 January 2012 (2012-01-05) * paragraphs [0002], [0006] * ----- | 1-14 | INV. H02G5/00 H05K7/14 |
| A | US 2024/212887 A1 (ZHANG RONG [CN] ET AL) 27 June 2024 (2024-06-27) * paragraph [0003] * ----- | 1-14 | |
| A | CN 217 692 559 U (ZHONGTIAN BROADBAND TECHNOLOGY CO LTD ET AL.) 28 October 2022 (2022-10-28) * paragraph [0002] * ----- | 1-14 | |
| A | CN 112 260 391 A (GOOGLE INC) 22 January 2021 (2021-01-22) * abstract * * ----- | 1-14 | |

**TECHNICAL FIELDS SEARCHED (IPC)**

H05K
G02B
G06F
H02G
H02B

The present search report has been drawn up for all claims

| Place of search | Date of completion of the search | Examiner |
|---|---|---|
| The Hague | 2 March 2026 | Bernardini, Andrea |

EPO FORM 1503 03.82 (P04C01)

## ANNEX TO THE EUROPEAN SEARCH REPORT
## ON EUROPEAN PATENT APPLICATION NO.

EP 25 21 1141

This annex lists the patent family members relating to the patent documents cited in the above-mentioned European search report.
The members are as contained in the European Patent Office EDP file on
The European Patent Office is in no way liable for these particulars which are merely given for the purpose of information.

02-03-2026

| Patent document cited in search report | Publication date | Patent family member(s) | | Publication date |
|---|---|---|---|---|
| US 2012000975 A1 | 05-01-2012 | US | 2012000975 A1 | 05-01-2012 |
| | | WO | 2012012082 A2 | 26-01-2012 |
| US 2024212887 A1 | 27-06-2024 | CN | 118281655 A | 02-07-2024 |
| | | EP | 4391262 A1 | 26-06-2024 |
| | | US | 2024212887 A1 | 27-06-2024 |
| CN 217692559 U | 28-10-2022 | NONE | | |
| CN 112260391 A | 22-01-2021 | CN | 112260391 A | 22-01-2021 |
| | | CN | 118868350 A | 29-10-2024 |
| | | EP | 3937601 A1 | 12-01-2022 |
| | | US | 2022011833 A1 | 13-01-2022 |
| | | US | 2023315170 A1 | 05-10-2023 |

EPO FORM P0459

For more details about this annex : see Official Journal of the European Patent Office, No. 12/82

**REFERENCES CITED IN THE DESCRIPTION**

**Patent documents cited in the description**

- US 63712254
- US 63892441

- US 36400625